# NEUE EUROPÄISCHE PATENTSCHRIFT

(11) **EP 3 247 987 B2**
(45) Veröffentlichungstag und Bekanntmachung des Hinweises auf die Entscheidung über den Einspruch: **25.10.2023**
(45) Hinweis auf die Patenterteilung: 02.09.2020
(21) Anmeldenummer: 16700591.7
(22) Anmeldetag: 14.01.2016
(51) Int. Cl.: G01N 1/42, H01J 37/18, H01J 37/20

(54) **PROBENTRANSFEREINRICHTUNG**
SAMPLE TRANSFER DEVICE
DISPOSITIF DE TRANSFERT D'ÉCHANTILLONS

(30) Priorität: 20.01.2015 DE 102015100727
(43) Veröffentlichungstag der Anmeldung: 29.11.2017
(60) Teilanmeldung: 20193728.1
(73) Patentinhaber: Leica Mikrosysteme GmbH, 1170 Wien (AT)
(72) Erfinder: GAECHTER, Leander, 9463 Oberriet SG (CH); BOCK, Günther, 1230 Wien (AT); PFEIFER, Thomas, 09405 Zschopau (DE)
(74) Vertreter: DehnsGermany Partnerschaft von Patentanwälten
(86) Internationale Anmeldenummer: PCT/EP2016/050606
(87) Internationale Veröffentlichungsnummer: WO 2016/116341

(56) Entgegenhaltungen:
- WO-A1-2009/116696
- WO-A1-2016/016001
- JP-A- 2013 257 148
- US-A1- 2009 078 060
- US-A1- 2012 027 086
- CHYONGERE HSIEH ET AL: "Practical workflow for cryo focused-ion-beam milling of tissues and cells for cryo-TEM tomography", JOURNAL OF STRUCTURAL BIOLOGY, Bd. 185, Nr. 1, 6. November 2013 (2013-11-06), Seiten 32-41, XP055211969, ISSN: 1047-8477, DOI: 10.1016/j.jsb.2013.10.019

## Beschreibung

Die Erfindung betrifft eine Probentransfereinrichtung zur Aufnahme einer Probe, insbesondere einer zu bearbeitenden und/oder mikroskopisch zu untersuchenden Probe, mit einer Transferstange, die zur Aufnahme eines Probenhalters ausgestaltet ist, wobei der Probenhalter zu Zwecken des Transfers der Probe zu einer Bearbeitungs- oder Analyseeinheit in einer Kammer der Probentransfereinrichtung anzuordnen ist.

### Stand der Technik

Derartige Probentransfereinrichtungen finden insbesondere in der Elektronenmikroskopie Verwendung. Zu untersuchende Proben, die beispielsweise Zellen, Enzyme, Viren oder Lipidschichten enthalten, werden kryofixiert, d.h. die wasserhaltige Probe wird sehr schnell unter Vermeidung der Bildung von Eiskristallen auf Temperaturen unter -150°C eingefroren. Hierbei können die biologischen Strukturen in ihrem nativen Zustand erhalten werden. Beispielsweise kann ein biologischer Vorgang zu jedem beliebigen Zeitpunkt durch Kryofixierung angehalten und zum Beispiel in einem Kryo-Elektronenmikroskop und/oder in einem Lichtmikroskop mit entsprechender Probenkühlung untersucht werden. Vor der eigentlichen Untersuchung können kryofixierte Proben in an sich bekannter Weise weiteren Präparationsschritten unterzogen werden, beispielsweise einer Bearbeitung mit Gefrierbruch-, Gefrierätz- und/oder Beschichtungstechniken.

Um die Qualität der gefrorenen Proben nicht zu beeinträchtigen, ist es von großer Bedeutung, dass sie kontaminationsfrei und ggf. gekühlt zwischen den zum Einsatz kommenden Bearbeitungsgeräten bzw. Analysegeräten transferiert werden. Unter Bearbeitungsgeräten oder Bearbeitungseinheiten seien beispielsweise eine Kryofixiereinrichtung, eine Gefrierbruchvorrichtung, eine Gefrierätzvorrichtung oder eine Beschichtungsvorrichtung verstanden, während unter Analysegeräten bzw. Analyseeinheiten beispielsweise ein Kryo-Elektronenmikroskop oder ein gekühltes Lichtmikroskop verstanden werden sollen.

Zu Zwecken der Übergabe bzw. des Transfers einer Probe an eine Bearbeitungs- oder Analyseeinheit werden sogenannte Probentransfereinrichtungen verwendet. Eine solche Probentransfereinrichtung stellt beispielsweise das Vakuumkryotransfersystem "Leica EM VCT100" (Hersteller: Leica Microsystems) dar, das in der gleichnamigen Broschüre beschrieben ist, die über den Link http://www.leica-microsystems.com/fileadmin/downloads/Leica%20EM %20VCT100/Brochures/Leica_EM VCT100_Brochure_EN.pdf zugänglich ist. Dieses Transfersystem weist eine Transferstange zur lösbaren Befestigung eines Probenhalters auf, wobei letzterer am Ende der Transferstange angeordnet wird. Befindet sich eine sehr kleine gefrorene elektronenmikroskopische Probe auf dem Probenhalter, so kann letzterer durch geeignete Verschiebung der Transferstange und Verbindung mit dem Probenhalter aufgenommen werden, wobei durch erneute (Zurück-)Verschiebung der Transferstange die Probe anschließend zu Zwecken des Transfers der Probe zu einer Bearbeitungs- oder Analyseeinheit in einer Kammer des Transfersystems angeordnet wird. Dort wird die Probe unter Schutzgas oder unter Hochvakuum und - soweit erforderlich - bei der für die weitere Kryobearbeitung bzw. Kryountersuchung erforderlichen Tieftemperatur gehalten. Der Anschluss des Transfersystems ist so ausgestaltet, dass darüber eine Hochvakuumverbindung zur Bearbeitungs- oder Analyseeinheit herstellbar ist. Darüber hinaus steht die Kammer bzw. der Probenhalter mit einem Kühlmittelreservoir, meist einem Dewar-Behälter, in Verbindung, der mit einem Kühlmittel, typischerweise flüssigen Stickstoff, befüllbar ist. Auf diese Weise wird der Probenhalter sowie die dort befindliche Probe gekühlt.

Abhängig von der jeweiligen Bearbeitungs- oder Analyseeinheit stehen eine Vielzahl unterschiedlicher Probenhalter zu Verfügung, die in der genannten Broschüre dargestellt sind. Nach Kryofixierung der Probe wird diese mit einem geeigneten Probenhalter in das Vakuumtransfersystem geladen. Anschließend erfolgt der Transfer zu der nachgeschalteten Bearbeitungs- oder Analyseeinheit. Der Transfer erfolgt in einem gekühlten Zustand, so dass die Probe nicht an- oder auftauen kann und damit unbrauchbar wird. Des Weiteren ist eine Kontamination beispielsweise bei Aussetzen der Probe an Umgebungsluft zu vermeiden. Damit die Probe beispielsweise unter Vakuum in das entsprechende Bearbeitungs- oder Analysegerät eingebracht werden kann, weisen Probentransfereinrichtungen, wie das beschriebene Vakuumkryotransfersystem "Leica EM VCT100" Vakuumschieber bzw. Schiebeventile auf. Beispielsweise ist ein Schiebeventil an der Anschlussstelle der Probentransfereinrichtung angeordnet und ein weiteres Schiebeventil an der entsprechenden Anschlussstelle des Bearbeitungs- oder Analysegeräts. Nach Anschluss der Probentransfereinrichtung an die Bearbeitungs- oder Analyseeinheit mit jeweils geschlossenen Schiebeventilen, wird der entstehende Zwischenraum nach Art einer Schleuse evakuiert. Anschließend werden die Schiebeventile geöffnet und die Probe unter Vakuum der Bearbeitungs- oder Analyseeinheit übergeben. Hierzu kann die Transferstange linear verschoben und häufig auch um ihre Achse gedreht werden.

Dokumente US2009078060 und CHYONGERE HSIEH ET AL:"Practical workflow for cryo focused-ionbeam milling of tissues and cells for cryo-TEM tomography",JOURNAL OF STRUCTURAL BIOLOGY, Bd. 185, Nr. 1, 6. November 2013, Seiten 32-41 stellen relevanten Stand der Technik dar.

Es hat sich gezeigt, dass Zustandsänderungen der Probe während des Transfers zu Schädigungen der Probe und damit zu unbrauchbaren Ergebnissen bei der Analyse bzw. zu Fehlinterpretationen führen können oder aber nachfolgende Bearbeitungsschritte erschweren oder gänzlich unmöglich machen. Der Probentransfer erfolgt basierend auf Erfahrungswerten häufig zeitgesteuert.

Aufgabe der vorliegenden Erfindung ist daher, die Wahrscheinlichkeit einer probenschädigenden Zustandsänderung weiter herabzusetzen bzw. eine derartige Zustandsänderung ohne größere Zeitverzögerung zu erkennen.

### Offenbarung der Erfindung

Zur Lösung dieser Aufgabe wird eine erfindungsgemäße Probentransfereinrichtung gemäß Anspruch 1 vorgeschlagen. Vorteilhafte Ausgestaltungen ergeben sich aus den Unteransprüchen und der nachfolgenden Beschreibung.

Eine erfindungsgemäße Probentransfereinrichtung weist eine Kammer auf, in der ein Probenhalter angeordnet werden kann. In dieser Kammer herrscht meist eine Schutzgasatmosphäre oder aber Vakuum (Hochvakuum). Meist herrschen in der Kammer Kryotemperaturen. Erfindungsgemäß ist wenigstens eine Messeinrichtung zur Messung einer physikalischen Größe innerhalb der Probentransfereinrichtung angeordnet.

Durch die Erfindung wird es möglich, physikalische Größen, die den Zustand einer in der Kammer befindlichen Probe beeinflussen, zu messen und ggf. auch zu überwachen.

Als physikalische Größen können insbesondere die Temperatur und der Druck in der Kammer der Probentransfereinrichtung genannt werden. Aber auch andere Größen sind denkbar, wie das Kammervolumen, die Teilchenzahl in der Atmosphäre der Kammer, die Lage und Orientierung einer Probe, die sich auf einem Probenhalter befindet, der wiederum mit der Transferstange der Probentransfereinrichtung verbunden ist. Auch die Messung der physikalischen Größe Zeit, beispielsweise die Dauer eines Transfers der Probe zu einer Bearbeitungs- oder Analyseeinheit bzw. zwischen Bearbeitungs- und/oder Analyseeinheiten, stellt eine wichtige Größe dar.

Mit "Messeinrichtung" ist im Rahmen dieser Anmeldung zunächst nur der Sensor oder die Sonde gemeint, der bzw. die die betreffende physikalische Größe misst, indem ein entsprechendes Signal (meist Spannungs- oder Stromsignal) erzeugt wird. Erst im weiteren Sinne, der ebenso umfasst sein soll, meint Messeinrichtung auch eine Schaltung bzw. Elektronik, die den genannten Sensor bzw. die genannte Sonde umfasst und ein Signal, das für die anschließende Weiterverarbeitung bereits aufbereitet sein kann, erzeugt.

Es ist vorteilhaft, wenn eine Messeinrichtung zur Messung eines in der Kammer herrschenden Drucks im Inneren der Probentransfereinrichtung vorhanden ist. Druckmesseinrichtungen sind an sich bekannt, sie umfassen beispielsweise piezoresistive oder piezoelektrische Drucksensoren, kapazitive oder induktive Drucksensoren etc. Im Vakuumbereich existieren entsprechend geeignete Drucksensoren, beispielsweise ein Wärmeleitungsvakuummeter oder ein Ionisations-Vakuummeter.

Des Weiteren ist es vorteilhaft, wenn eine Messeinrichtung zur Messung einer in der Kammer der Probentransfereinrichtung herrschenden Temperatur vorhanden ist. Zur Aufnahme eines Probenhalters ist die Transferstange mit einem entsprechenden Greifer ausgerüstet. Über die Transferstange wird der Probenhalter mit der darauf angeordneten Probe zu bzw. von einer in der Kammer angeordneten Probenbühne transferiert. Die Temperaturmesseinrichtung kann beispielsweise mit einem der genannten Elemente, vorzugsweise der Probenbühne, verbunden sein, soweit dieses Element wärmeleitend mit dem Probenhalter und der hierauf befindlichen Probe verbunden ist. Die Anordnung einer Messeinrichtung an einem solchen mit der Transferstange der Probentransfereinrichtung verbundenen Element soll im Sinne dieser Anmeldung von einer "Anordnung innerhalb der Probentransfereinrichtung" umfasst sein. Es ist vorteilhaft, die Temperatur der Probenbühne mittels eines Temperatursensors zu messen, der an der Probenbühne angeordnet ist. Da die Probenbühne und der Probenhalter mit der Probe wärmeleitend miteinander verbunden sind, kann hierdurch in guter Näherung die Probentemperatur bestimmt werden. Temperatursensoren sind an sich bekannt. Hier sind insbesondere Heiß- und Kaltleiter zu nennen, deren Widerstand von der Temperatur abhängt, und die daher zur Temperaturmessung eingesetzt werden können. Auf der anderen Seite existieren integrierte Halbleiter - Temperatursensoren, die abhängig von der Temperatur einen proportionalen Strom, eine proportionale Spannung oder allgemein ein temperaturabhängiges Signal liefern. Darüber hinaus sind auch andere Temperatursensoren bekannt.

Da bislang bekannte Probentransfereinrichtungen über kein eigenes Messsystem für den Zustand einer Probe beeinflussende physikalische Größen verfügen, war es bisher nicht möglich, beispielsweise die Probentemperatur und den Druck nach dem Schließen der Kammer der Probentransfereinrichtung zu messen. Erst nachdem die Probe in ein folgendes Bearbeitungs- oder Analysegerät übergeben worden war, konnte die Probe wieder in einen definierten Zustand gebracht werden. Eine Messung beispielsweise der Probentemperatur und des Drucks konnte erst im entsprechenden Bearbeitungs- oder Analysegerät erfolgen. Die Historie des Probenzustands während des Transfers war unbekannt. Mit der vorliegenden Erfindung ist es nunmehr möglich, den Zustand der Probe anhand der den Probenzustand bestimmenden physikalischen Größen mittels der wenigstens einen Messeinrichtung im Inneren der Probentransfereinrichtung zu bestimmen.

Die Messung der mindestens einen physikalischen Größe kann hierbei vor dem eigentlichen Transfer, während des Transfers und/oder nach dem eigentlichen Transfer erfolgen. Dies hängt auch davon ab, ob die in der Probentransfereinrichtung vorhandenen Messeinrichtungen selbst über eine Stromversorgung verfügen. Es sei darauf hingewiesen, dass eine eigene Stromversorgung nicht unbedingt erforderlich ist. In der Regel erfolgt der Transfer von einer Ladestation zu einer Bearbeitungseinheit, zwischen zwei Bearbeitungseinheiten oder zwischen einer Bearbeitungseinheit und einer Analyseeinheit oder auch zwischen zwei Analyseeinheiten, wobei die genannten Einheiten jeweils über eine Andockstation verfügen, an die eine Probentransfereinrichtung angeschlossen werden kann. Es ist prinzipiell möglich, die Stromversorgung der wenigstens einen Messeinrichtung im Inneren der Probentransfereinrichtung über eine solche Andockstation zu realisieren und entsprechend auch die Messung und Übertragung von Messwerten in die Andockstation erst nach Andocken vorzunehmen, von wo aus eine Weiterverarbeitung der Messwerte erfolgt.

In einem solchen Fall würden die genannten physikalischen Größen, wie Temperatur und Druck, an den jeweiligen Andockstationen gemessen werden. Im abgekoppelten Zustand, das heißt während eines Transfers, wäre dann die elektrische Versorgung der wenigstens einen Messeinrichtung unterbrochen. Die fehlenden Messwerte während des Transfers können dann zweckmäßigerweise interpoliert werden.

Auf diese Weise erhält man eine ausreichend genaue Beschreibung der Historie des Probenzustands jeweils durch Messwerte beim Andocken an die genannten Einheiten (Lade-, Bearbeitungs- und Analyseeinheiten) sowie während des Transfers (durch Interpolation). Dies lässt eine Identifizierung von probenschädigenden Zustandsänderungen zu, die insbesondere unmittelbar nach dem Andocken an eine der genannten Einheiten erkannt werden können. Dies kann unbrauchbare Ergebnisse oder Fehlinterpretationen bei der nachfolgenden Analyse vermeiden oder aber auch für eine Weiterbearbeitung ungeeignete Probenzustände von vornherein erkennen.

Es ist weiterhin vorteilhaft, wenn eine Zeitmesseinrichtung innerhalb der Probentransfereinrichtung vorhanden ist. Eine solche Zeitmesseinrichtung kann beispielsweise bei einem Entfernen der Probentransfereinrichtung von einer Andockstation aktiviert und bei erneutem Andocken an eine Andockstation deaktiviert werden, sodass als Messgröße die Transferzeit gemessen wird. Diese Transferzeit kann beispielsweise über die Andockstation der jeweiligen Einheit übertragen und verarbeitet werden. Liegt diese Transferzeit beispielsweise oberhalb einem zulässigen Grenzwert, so kann dies ein Indiz für eine probenschädigende Zustandsänderung sein. Alternativ oder zusätzlich (zur Verifizierung) kann die Historie weiterer physikalischer Größen, wie Temperatur und Druck, herangezogen werden, um eine etwaige Probenschädigung zu identifizieren.

Anstelle einer Interpolation von Messwerten kann es auch sinnvoll und zweckmäßig sein, kontinuierlich oder zumindest in bestimmten Zeitabständen die jeweiligen physikalischen Größen während eines Transfers zu messen. Hierzu ist insbesondere ein Akkumulator zur Stromversorgung der wenigstens einen Messeinrichtung beispielsweise innerhalb der Probentransfereinrichtung angeordnet. Es sind auch andere Energielieferanten, wie Batterien, oder eine kabellose Energieübertragung (induktive, kapazitive Einspeisung) denkbar und möglich. Ein Akkumulator hat den Vorteil, dass er in einfacher Weise beispielsweise beim Andocken der Probentransfereinrichtung über die Andockstation geladen werden kann. Bei einer Anordnung des Akkumulators innerhalb der Probentransfereinrichtung ist auf eine ausreichende temperatur- und/oder druckisolierte Abkapselung zu achten. Um dies zu umgehen, kann der Akkumulator (oder sonstige Energielieferant) auch außerhalb, beispielsweise am Gehäuse der Probentransfereinrichtung angeordnet werden und beispielsweise über entsprechende druck- und/oder temperaturfeste Anschlüsse mit der wenigstens einen Messeinrichtung im Inneren der Probentransfereinrichtung verbunden sein.

Es ist besonders vorteilhaft, wenn eine Steuerelektronik vorhanden ist, die derart mit der wenigstens einen Messeinrichtung in Wirkverbindung steht, dass eine Messung durch die betreffende Messeinrichtung initiiert werden kann und/oder Messwerte der betreffenden Messeinrichtung von der Steuerelektronik empfangen werden können. Auf diese Weise können die notwendigen Mess-, Steuerungs- und etwaigen Regelprozesse über eine integrierte Steuerelektronik erfolgen. Die Steuerelektronik kann - wie der Akkumulator - innerhalb oder außerhalb der Probentransfereinrichtung angeordnet sein. Insofern gelten hier dieselben Aussagen wie für den Akkumulator.

Eine erfindungsgemäße Probentransfereinrichtung verfügt über einen Anschluss zu den jeweiligen Andockstationen nachfolgender Bearbeitungs- oder Analysegeräte. Es ist vorteilhaft, wenn der entsprechende Anschluss der Probentransfereinrichtung eine Schnittstelle aufweist, über die Messwerte der wenigstens einen Messeinrichtung an die angeschlossene Bearbeitungs- oder Analyseeinheit oder an eine mit dieser in Verbindung stehenden Andockstation übertragen werden. Weiterhin ist vorteilhaft, wenn über diese Schnittstelle die wenigstens eine Messeinrichtung mit Strom versorgt wird, sobald die Probentransfereinrichtung an die betreffende Bearbeitungs- oder Analyseeinheit angedockt ist. Die Übertragung der Messwerte einerseits und die Stromversorgung andererseits können insbesondere über eine vorhandene Steuerelektronik erfolgen und gesteuert werden. Schließlich kann auch die Steuerelektronik selbst ausschließlich oder zusätzlich mit Strom über die erwähnte Schnittstelle versorgt werden.

Wenn ein Akkumulator in oder an der Probentransfereinrichtung vorhanden ist, ist es vorteilhaft, diesen über die Schnittstelle mittels einer externen Stromquelle aufzuladen.

Eine erfindungsgemäße Probentransfereinrichtung weist eine Transferstange auf, an deren Ende ein Probenhalter lösbar befestigbar ist. Bei der erfindungsgemäßen Probentransfereinrichtung ist durch lineare Bewegung der Transferstange die Lage des Probenhalters und somit auch die der Probe veränderbar. Erfindungsgemäß ist auch durch Drehung der Transferstange um ihre Achse die Orientierung des Probenhalters und somit der Probe veränderbar. Die Probentransfereinrichtung kann zum Zwecke der Aufnahme eines Probenhalters auch eine Probenbühne aufweisen, die sich am Ende der Transferstange befindet. In diesem Zusammenhang ist es vorteilhaft, wenn durch eine weitere Messeinrichtung die Lage der Probenbühne bzw. des Probenhalters und/oder eine entsprechende Bewegung (x) der Transferstange erfasst wird und/oder die Orientierung der Probenbühne bzw. des Probenhalters und/oder eine entsprechende Drehung (a) der Transferstange erfasst wird. Weiterhin kann es sinnvoll sein, die Lage und Orientierung der Probe im Raum zu messen oder aus Messwerten der genannten Messeinrichtung abzuleiten. Hieraus lässt sich eine Historie der Probenposition während eines Transfers oder zumindest vor und nach einem Transfer erstellen. Die genannte Messeinrichtung kann einen Lage- und/oder Bewegungssensor darstellen, der im Inneren der Probentransfereinrichtung, insbesondere im Inneren der Kammer der selbigen angeordnet ist. Alternativ kann es zweckmäßig sein, eine Bewegung (x) und/oder eine Drehung (α) durch entsprechende (bekannte) Sensoren an der Transferstange außerhalb der Probentransfereinrichtung zu messen.

Es kann vorteilhaft sein, wenn die genannte Steuerelektronik ein Warnsignal erzeugt, wenn ein Messwert der wenigstens einen Messeinrichtung einen vorbestimmten Grenzwert überschreitet oder unterschreitet. Überschreitet beispielsweise der Druck in einer Vakuumkammer einen höchsten zulässigen Grenzwert, wird ein entsprechendes Warnsignal erzeugt, das unmittelbar nach außen übertragen werden kann (beispielsweise über Funk) oder das unmittelbar beim Andocken der Probentransfereinrichtung an eine Andockstation übertragen und angezeigt werden kann (akustische und/oder optische Anzeige). Gleiches gilt in analoger Weise beispielsweise für den Messwert der Temperatur, insbesondere bei kryofixierten Proben. Wiederum analoges gilt für den oben erläuterten Messwert der Zeitdauer eines Transfers, die beispielsweise unterhalb eines vorgegebenen Grenzwerts liegen sollte.

Die Erfindung betrifft weiterhin ein System mit einer erfindungsgemäßen Probentransfereinrichtung, die eine Schnittstelle zu einer Andockstation einer Bearbeitungs- oder Analyseeinheit aufweist, und mit einer solchen Andockstation. Hierbei ist es vorteilhaft, wenn die Schnittstelle der Probentransfereinrichtung über einen Kontakt, insbesondere über einen elektrischen, weiter insbesondere einen federnden elektrischen Kontakt sowie die Andockstation über einen entsprechenden Kontakt, insbesondere einen elektrischen, insbesondere ebenfalls einen federnden elektrischen Kontakt verfügt, wobei diese Kontakte derart angeordnet und ausgestaltet sind, dass bei einem Verbinden der Probentransfereinrichtung und der Andockstation die genannten Kontakte miteinander in Wirkverbindung treten. Auf diese Weise können dann insbesondere die genannten Messwerte an die Andockstation und/oder an die zugeordnete Bearbeitungs- oder Analyseeinheit übertragen werden. Andererseits kann die wenigstens eine Messeinrichtung und/oder die Steuerelektronik der Probentransfereinrichtung über die miteinander verbundenen Kontakte mit Strom versorgt werden.

Weitere Ausgestaltungen und Vorteile des erfindungsgemäßen Systems ergeben sich aus der Beschreibung der erfindungsgemäßen Probentransfereinrichtung in analoger Art und Weise.

Weitere Vorteile und Ausgestaltungen der Erfindung ergeben sich aus der Beschreibung der beiliegenden Zeichnung.

Die Erfindung ist anhand eines Ausführungsbeispieles in der Zeichnung schematisch dargestellt und wird im Folgenden unter Bezugnahme auf die Zeichnung beschrieben.

### Figurenbeschreibung

Figur 1 zeigt einen schematischen Querschnitt durch eine Ausführungsform einer erfindungsgemäßen Probentransfereinrichtung;
Figur 2 zeigt eine schematische perspektivische Ansicht der Probentransfereinrichtung aus Figur 1 und eine geeignete Andockstation in zwei verschiedenen Ansichten (Figur 2A und 2B);
Figur 3 zeigt die Probentransfereinrichtung und die Andockstation aus Figur 2 nach dem Andocken; und
Figur 4 zeigt eine mögliche Wirkverbindung zwischen Probentransfereinrichtung, Andockstation, einem Bearbeitungsgerät, einer Steuereinheit und einem Display.

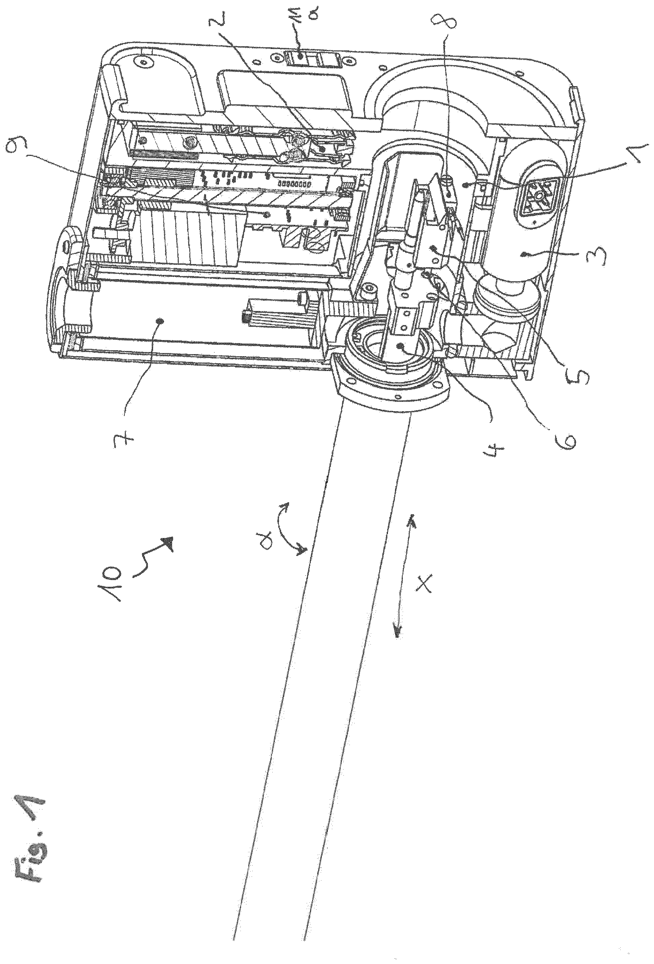

Figur 1 zeigt schematisch einen Querschnitt durch eine Probentransfereinrichtung 10. In einem Gehäuse der Probentransfereinrichtung 10 ist ein Schiebeventil 2 angeordnet, über das eine (Vakuum-)Kammer 1 verschlossen werden kann. An diese Kammer ist eine Druckmesssonde 3 als Druckmesseinrichtung angeflanscht. Diese Sonde 3 misst im aktivierten Zustand den Druck (p) in der Kammer 1. In der Kammer 1 befindet sich eine Probenbühne 5, die mit einem Probenhalter für eine Probe mechanisch lösbar verbunden werden kann. Mittels einer Transferstange 4 kann eine auf dem Probenhalter befestigte Probe (nicht dargestellt), linear (x) verschoben, das heißt bei geöffnetem Schiebeventil 2 in eine Bearbeitungs- oder Analyseeinheit übergeben werden. Zum Transfer beispielsweise von einer Bearbeitungseinheit in eine Analyseeinheit wird durch entsprechende Bewegung der Transferstange 4 die Probe in das Innere der Kammer 1 verbracht und bei definierter Temperatur und definiertem Druck von der Bearbeitungseinheit zur Analyseeinheit transferiert. Die Transferstange 4 ist um ihre Achse drehbar (a). Die Probenbühne 5 ist über ein Verbindungselement 6 mit einem Vorratsgefäß 7 verbunden. In dem Vorratsgefäß 7 befindet sich ein Kühlmittel, typischerweise flüssiger Stickstoff. Als eine zweite Messeinrichtung befindet sich ein Temperatursensor 8 an der Probenbühne 5. Dieser misst im aktivierten Zustand die Temperatur der Probenbühne 5 und somit des mit ihr verbunden Probenhalters einschließlich der Probe. Die Messwerte der Druckmesseinrichtung 3 sowie der Temperaturmesseinrichtung 8 werden an eine Steuerelektronik 9 geleitet. Alternativ oder zusätzlich können durch entsprechende vakuumdichte Anschlüsse im Gehäuse der Probentransfereinrichtung die entsprechenden Messleitungen der Messeinrichtungen auch nach außen geführt werden, um von einer beispielsweise am Gehäuse der Probentransfereinrichtung befindlichen Steuerelektronik weiterverarbeitet zu werden.

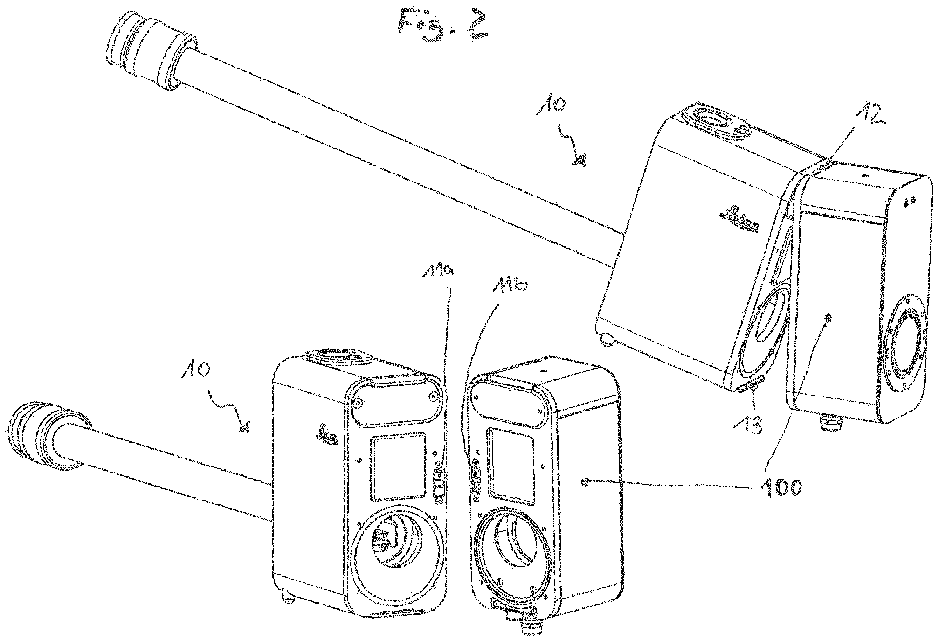

Die Probentransfereinrichtung 10 verfügt über einen Anschluss (Stirnseite des Gehäuses) zu einer Andockstation 100 (vgl. Figur 2). Der Anschluss verfügt über eine Schnittstelle mit einem elektrischen Kontakt 11a. Weiterhin verfügt der Anschluss über eine Öffnung, durch die eine Übergabe der Probe aus der Kammer 1 in die entsprechende Bearbeitungs- oder Analyseeinheit erfolgen kann.

Figur 2 zeigt die Probentransfereinrichtung 10 und eine Andockstation 100, die in der Regel mit dem betreffenden Bearbeitungs- oder Analysegerät fest verbunden ist. In diesem Ausführungsbeispiel erfolgen der Datentransfer der Messwerte der Druckmesseinrichtung 3 und der Temperaturmesseinrichtung 8 und die elektrische Versorgung der Probentransfereinrichtung über die genannte Schnittstelle, die auf Seiten der Probentransfereinrichtung einen federnden elektrischen Kontakt 11a aufweist. Ein hierzu passender Kontakt 11b ist an der Andockstation 100 vorhanden. Die Probentransfereinrichtung 10 wird über eine mechanische Positionierung (Anschlag) 12 und eine Verriegelung 13 mit der Andockstation 100 vakuumdicht verbunden. In diesem Zustand werden die Federkontakte 11a und 11b passgenau zueinander positioniert. Über die hierdurch entstehende Schnittstelle (bspw. auch eine RS-232-Schnittstelle) erfolgt die elektrische Versorgung und somit die Aktivierung der Messeinrichtungen in der Probentransfereinrichtung (im vorliegenden Beispiel besitzt die Probentransfereinrichtung keine eigene Stromversorgung). Als physikalische Größen werden Temperatur und Druck aus der geschlossenen Vakuumkammer 1 kontinuierlich gemessen und über die Schnittstelle an ein oder mehrere weitere Geräte, wie weiter unten erläutert, übertragen. Die Steuerelektronik 9 kann über eine Zeitmesseinrichtung verfügen, die beim Abdocken aktiviert und bei erneutem Andocken gestoppt wird. Auf diese Weise kann die Transferdauer gemessen werden. Zusätzlich werden weitere Messgrößen, wie zum Beispiel die Lage und Orientierung der Probenbühne 5 bzw. der Transferstange 4 sowie die Position des Schiebeventils 2 sensorisch erfasst. Üblicherweise erfolgt das Andocken bei geschlossenem Schiebeventil 2 und entsprechend geschlossenem Schiebeventil (nicht dargestellt) in der Andockstation 100. Der entstehende Zwischenraum wird nach Art einer Schleuse evakuiert. Daraufhin werden die Schiebeventile geöffnet und die Übergabe der Probe kann eingeleitet werden.

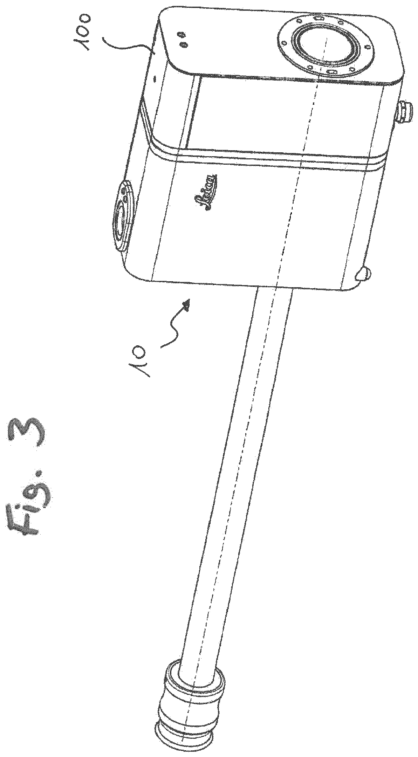

Figur 3 zeigt die Probentransfereinrichtung 10 im angedockten Zustand, das heißt mechanisch und elektrisch mit der Andockstation 100 (und dem nachfolgenden Bearbeitungs- oder Analysegerät) verbunden.

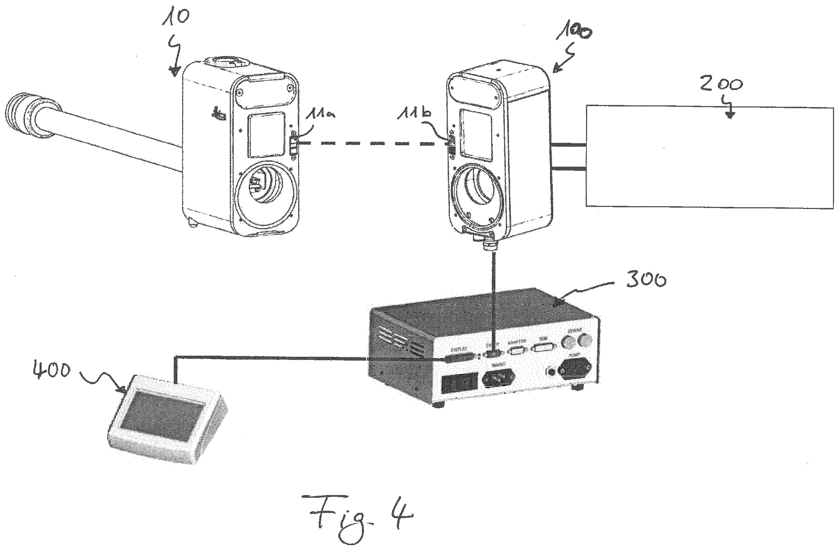

Figur 4 zeigt die entsprechende Wirkverbindung, über die Messdaten der Messeinrichtungen im Inneren der Probentransfereinrichtung 10 an externe Geräte weiter gegeben werden können. Dies erfolgt über die bereits erwähnte Schnittstelle, über die Messdaten an die Andockstation 100 und von dort an ein angeschlossenes Bearbeitungsgerät 200 und/oder über eine Steuereinheit 300 an ein Display 400 (Anzeige), beispielsweise ein TFT-Bildschirm, gegeben werden können. Liegen die Messdaten der entsprechenden Messeinrichtungen außerhalb erlaubter Grenzen, so kann dies entsprechend angezeigt und als Indiz für eine probenschädigende Zustandsänderung gewertet werden. Von einer nachfolgenden Bearbeitung oder Analyse der Probe kann dann abgesehen werden.

Im hier dargestellten Ausführungsbeispiel werden die Messdaten, speziell für den Druck und die Probentemperatur, bei der Probenübergabe, also im jeweils angedockten Zustand erfasst. Im abgekoppelten Zustand, also während eines Transfers, ist die elektrische Versorgung der Probentransfereinrichtung unterbrochen und damit die Steuerelektronik 9 bzw. die Messeinrichtungen 3 und 8 deaktiviert. Nach erneutem Andocken an die folgende Bearbeitungs- oder Analyseeinheit 200 (vgl. Figur 4) und noch vor der Probenübergabe wird die Steuerelektronik 9 bzw. die Messeinrichtungen 3 und 8 aktiviert. Die aktuellen Messdaten, speziell Druck und Probentemperatur, werden erfasst. Fehlende Messwerte während des Transfers können in einfacher Weise durch die Steuerelektronik interpoliert werden. Sollte eine kontinuierliche oder über bestimmte Zeitintervalle erfolgende Erfassung von Messwerten während eines Transfers erforderlich oder sinnvoll sein, so ist eine Stromversorgung der Steuerelektronik 9 bzw. der Messeinrichtungen 3 und 8 erforderlich, die in einfacher Weise über einen Akkumulator bewerkstelligt werden kann, der insbesondere in angedocktem Zustand jeweils geladen werden kann.

Die in Figur 4 dargestellten Elemente, Probentransfereinrichtung 10, Andockstation 100, Bearbeitungseinheit 200, Steuereinheit 300 und Display 400 können auch in anderer Weise konfiguriert sein. Beispielsweise kann die Steuereinheit 300 in das Bearbeitungsgerät 200 integriert sein. In gleicher Weise kann das Display 400 in die Steuereinheit 300 und/oder in das Bearbeitungsgerät 200 integriert sein. Bezüglich der Probentransfereinrichtung 10 sei nochmals festgestellt, dass die im Zusammenhang mit Figur 1 erläuterte Steuerelektronik 9 auch außen am Gehäuse der Probentransfereinrichtung 10 angeordnet sein kann; gleiches gilt für einen etwaige vorhandenen Akkumulator und/oder für ein etwaig vorhandenes eigenes Display. In diesem Fall könnten externe Steuereinheit 300 und Display 400 ersetzt werden durch die am Gehäuse der Probentransfereinrichtung 10 vorhandene Steuerelektronik mit einem entsprechend ausgebildeten Display, das zweckmäßigerweise ebenfalls am Gehäuse der Probentransfereinrichtung 10 angeordnet ist. Bei einer solchen Ausführungsform könnte - unabhängig von einem Andocken an eine Andockstation 100 - autark von der Probentransfereinrichtung fortlaufend der Zustand einer Probe in der Probentransfereinrichtung 10 durch entsprechende Messung, Weiterverarbeitung der Messwerte und Anzeige der selbigen überwacht werden.

### Bezugszeichenliste

- 1: Kammer
- 2: Schiebeventil
- 3: Druckmesseinrichtung
- 4: Transferstange
- 5: Probenbühne
- 6: Verbindungselement
- 7: Vorratsgefäß
- 8: Temperaturmesseinrichtung
- 9: Steuerelektronik
- 10: Probentransfereinrichtung
- 11a: Kontakt
- 11b: Kontakt
- 12: mechanische Positionierung, Anschlag
- 100: Andockstation
- 200: Bearbeitungseinheit
- 300: Steuereinheit
- 400: Display, Anzeige

## Patentansprüche

1. Probentransfereinrichtung (10) zur Aufnahme einer Probe, mit einer Transferstange (4), die zur Aufnahme eines Probenhalters ausgestaltet ist, wobei der Probenhalter an einem Ende der Transferstange (4) lösbar befestigbar ist, wobei die Probentransfereinrichtung (10) einen Anschluss zu einer Andockstation (100) einer Bearbeitungs- oder Analyseeinheit (200) aufweist,
wobei der Probenhalter zu Zwecken des Transfers der Probe zu einer Bearbeitungs- oder Analyseeinheit (200) in einer Kammer (1) der Probentransfereinrichtung (10) anzuordnen ist, wobei der Probenhalter zum Transfer der Probe von einer Bearbeitungs- oder Analyseeinheit durch Bewegung der Transferstange (4) in ein Inneres der Kammer verbringbar ist,
wobei durch lineare Bewegung der Transferstange die Lage des Probenhalters und durch Drehung der Transferstange um ihre Achse eine Orientierung des Probenhalters veränderbar sind,
**dadurch gekennzeichnet,**
**dass** wenigstens eine Messeinrichtung (3, 8) zur Messung einer physikalischen Größe, die den Zustand der in der Kammer befindlichen Probe beeinflusst, innerhalb der Probentransfereinrichtung (10) angeordnet ist.

2. Probentransfereinrichtung nach Anspruch 1, **dadurch gekennzeichnet, dass** die wenigstens eine Messeinrichtung eine Messeinrichtung (3) zur Messung eines in der Kammer (1) herrschenden Drucks und/oder eine Messeinrichtung (8) zur Messung einer in der Kammer (1) herrschenden Temperatur und/oder eine Zeitmesseinrichtung umfasst.

3. Probentransfereinrichtung nach Anspruch 2 mit einer Probenbühne (5), die zur Aufnahme des Probenhalters ausgestaltet ist, **dadurch gekennzeichnet, dass** die Messeinrichtung (8) zur Messung der Temperatur an der Probenbühne (5) angeordnet ist.

4. Probentransfereinrichtung nach einem der voranstehenden Ansprüche, **dadurch gekennzeichnet, dass** zur Stromversorgung der wenigstens einen Messeinrichtung (3, 8) ein Akkumulator innerhalb oder außerhalb der Probentransfereinrichtung (10) angeordnet ist.

5. Probentransfereinrichtung nach einem der voranstehenden Ansprüche, **dadurch gekennzeichnet, dass** eine Steuerelektronik (9) vorhanden ist, die derart mit der wenigstens einen Messeinrichtung (3, 8) in Wirkverbindung steht, dass eine Messung durch die betreffende Messeinrichtung (3, 8) initiiert werden kann und/oder Messwerte der betreffenden Messeinrichtung (3, 8) von der Steuerelektronik (9) empfangen werden können.

6. Probentransfereinrichtung nach Anspruch 5, **dadurch gekennzeichnet, dass** die Steuerelektronik (9) innerhalb der Probentransfereinrichtung (10) angeordnet ist.

7. Probentransfereinrichtung nach einem der voranstehenden Ansprüche, **dadurch gekennzeichnet, dass** die Probentransfereinrichtung (10) eine Schnittstelle zu einer Andockstation (100) einer Bearbeitungsoder Analyseeinheit (200) aufweist.

8. Probentransfereinrichtung nach Anspruch 7, **dadurch gekennzeichnet, dass** die Schnittstelle derart ausgestaltet ist, dass Messwerte der wenigstens einen Messeinrichtung (3, 8) an die Bearbeitungs- oder Analyseeinheit (200) und/oder an die zugeordnete Andockstation (100) übertragen werden können, und/oder derart, dass über die Schnittstelle die wenigstens eine Messeinrichtung (3, 8) und/oder die Steuerelektronik (9) gemäß Anspruch 5 mit Strom versorgt werden.

9. Probentransfereinrichtung nach Anspruch 7 oder 8, soweit auf Anspruch 4 zurückbezogen, **dadurch gekennzeichnet, dass** die Schnittstelle derart ausgestaltet ist, dass über die Schnittstelle der Akkumulator mittels einer externen Stromquelle aufgeladen werden kann.

10. Probentransfereinrichtung nach einem der voranstehenden Ansprüche, **dadurch gekennzeichnet, dass** die Probentransfereinrichtung (10) eine Transferstange (4) zum Verändern der Lage und/oder Orientierung eines an der Transferstange (4) befestigten Probenhalters aufweist.

11. Probentransfereinrichtung nach Anspruch 10, **dadurch gekennzeichnet, dass** eine weitere Messeinrichtung zur Erfassung der Lage und/oder Orientierung des Probenhalters und/oder einer entsprechenden Bewegung der Transferstange (4) vorhanden ist.

12. Probentransfereinrichtung nach einem der voranstehenden Ansprüche, soweit auf Anspruch 5 zurückbezogen, **dadurch gekennzeichnet, dass** die Steuerelektronik (9) ein Warnsignal erzeugt, wenn ein Messwert der wenigstens eine Messeinrichtung (3, 8) einen vorbestimmten Grenzwert über- oder unterschreitet.

13. System mit einer Probentransfereinrichtung (10) gemäß einem der voranstehenden Ansprüche, soweit auf Anspruch 7 zurückbezogen, und mit einer Andockstation (100) für eine Bearbeitungs- oder Analyseeinheit (200).

14. System nach Anspruch 13, bei dem die Schnittstelle der Probentransfereinrichtung (10) über einen Kontakt (11a) und die Andockstation (100) über einen entsprechenden Kontakt (11b) verfügt, wobei diese Kontakte (11a, 11b) derart angeordnet und ausgestaltet sind, dass bei einem Verbinden von Probentransfereinrichtung (10) und Andockstation (100) die Kontakte (11a, 11b) miteinander in Wirkverbindung treten.

15. System nach Anspruch 14, bei dem die Wirkverbindung derart ausgestaltet ist, dass nach einem Verbinden von Probentransfereinrichtung (10) und Andockstation (100) über die Kontakte (11a, 11b) der Probentransfereinrichtung (10) und der Andockstation (100) Messwerte der wenigstens einen Messeinrichtung (3, 8) der Probentransfereinrichtung (10) an die Andockstation (100) und/oder an die zugeordnete Bearbeitungs- oder Analyseeinheit (200) übertragen werden und/oder die wenigstens eine Messeinrichtung (3, 8) und/oder die Steuerelektronik (9) gemäß Anspruch 5 mit Strom versorgt werden.

## Claims

1. Sample transfer device (10) for receiving a sample, with a transfer rod (4) configured to receive a sample holder, the sample holder being detachably attachable to one end of the transfer rod (4), the sample transfer device (10) having a connection to a docking station (100) of a processing or analysis unit (200)
wherein the sample holder is to be arranged in a chamber (1) of the sample transfer device (10) for the purpose of transferring the sample to a processing or analysis unit (200), wherein the sample holder is movable into an interior of the chamber for transferring the sample from a processing or analysis unit by movement of the transfer rod (4),
wherein the position of the sample holder can be changed by linear movement of the transfer rod and an orientation of the sample holder can be changed by rotation of the transfer rod about its axis,
**characterised in**
**that** at least one measuring device (3, 8) for measuring a physical quantity, which influences the state of the sample located in the chamber, is arranged within the sample transfer device (10).

2. Sample transfer device according to claim 1, **characterized in that** the at least one measuring device comprises a measuring device (3) for measuring a pressure prevailing in the chamber (1) and/or a measuring device (8) for measuring a temperature prevailing in the chamber (1) and/or a time measuring device.

3. Sample transfer device according to claim 2 with a sample platform (5) which is configured to receive the sample holder, **characterised in that** the measuring device (8) for measuring the temperature is arranged on the sample platform (5).

4. Sample transfer device according to one of the preceding claims, **characterized in that** an accumulator is arranged inside or outside the sample transfer device (10) for supplying power to the at least one measuring device (3, 8).

5. Sample transfer device according to one of the preceding claims, **characterised in that** control electronics (9) are provided which are operatively connected to the at least one measuring device (3, 8) in such a way that a measurement can be initiated by the respective measuring device (3, 8) and/or measured values from the respective measuring device (3, 8) can be received by the control electronics (9).

6. Sample transfer device according to claim 5, **characterized in that** the control electronics (9) are arranged within the sample transfer device (10).

7. Sample transfer device according to one of the preceding claims, **characterized in that** the sample transfer device (10) comprises an interface to a docking station (100) of a processing or analysis unit (200).

8. Sample transfer device according to claim 7, **characterized in that** the interface is configured in such a way that measured values of the at least one measuring device (3, 8) can be transmitted to the processing or analysis unit (200) and/or to the associated docking station (100), and/or in such a way that the at least one measuring device (3, 8) and/or the control electronics (9) according to claim 5 are supplied with current via the interface.

9. Sample transfer device according to claim 7 or 8, when dependent upon claim 4, **characterized in that** the interface is configured in such a way that the accumulator can be charged via the interface by means of an external current source.

10. Sample transfer device according to one of the preceding claims, **characterized in that** the sample transfer device (10) comprises a transfer rod (4) for changing the position and/or orientation of a sample holder attached to the transfer rod (4).

11. Sample transfer device according to claim 10, **characterized in that** a further measuring device is provided for detecting the position and/or orientation of the sample holder and/or a corresponding movement of the transfer rod (4).

12. Sample transfer device according to one of the preceding claims, when dependent upon claim 5, **characterized in that** the control electronics (9) generate a warning signal when a measured value of the at least one measuring device (3, 8) exceeds or falls below a predetermined limit value.

13. System with a sample transfer device (10) according to any of the preceding claims, when dependent upon claim 7, and with a docking station (100) for a processing or analysis unit (200).

14. System according to claim 13, in which the interface of the sample transfer device (10) has a contact (11a) and the docking station (100) has a corresponding contact (IIb), wherein these contacts (11a, 11b) are arranged and configured in such a way that when connecting sample transfer device (10) and docking station (100), the contacts (11a, 11b) come into operative connection with one another.

15. System according to claim 14, in which the operative connection is configure in such a way that after a connection of sample transfer device (10) and docking station (100) via the contacts (11a, 11b) of the sample transfer device (10) and the docking station (100), measured values of the at least one measuring device (3, 8) of the sample transfer device (10) are transmitted to the docking station (100) and/or to the associated processing or analysis unit (200) and/or the at least one measuring device (3, 8) and/or the control electronics (9) according to claim 5 are supplied with current.

## Revendications

1. Dispositif de transfert d'échantillons (10) pour la réception d'un échantillon, avec une tige de transfert (4) qui est conçue pour recevoir un porte-échantillon, le porte-échantillon pouvant être fixé de manière amovible à une extrémité de la tige de transfert (4), le dispositif de transfert d'échantillons (10) présentant un raccordement à une station d'amarrage (100) d'une unité de traitement ou d'analyse (200),
le porte-échantillon devant être disposé dans une chambre (1) du dispositif de transfert d'échantillons (10) pour transférer l'échantillon à une unité de traitement ou d'analyse (200), le porte-échantillon pouvant être déplacé à l'intérieur de la chambre par un mouvement de la tige de transfert (4) pour le transfert de l'échantillon depuis une unité de traitement ou d'analyse,
la position du porte-échantillon pouvant être modifiée par un mouvement linéaire de la tige de transfert et une orientation du porte-échantillon pouvant être modifiée par une rotation de la tige de transfert autour de son axe,
**caractérisé en ce**
**qu'**au moins un dispositif de mesure (3, 8) destiné à mesurer une grandeur physique qui influence l'état de l'échantillon se trouvant dans la chambre est disposé à l'intérieur du dispositif de transfert d'échantillon (10).

2. Dispositif de transfert d'échantillons selon la revendication 1, **caractérisé en ce que** le au moins un dispositif de mesure comprend un dispositif de mesure (3) pour mesurer une pression régnant dans la chambre (1) et/ou un dispositif de mesure (8) pour mesurer une température régnant dans la chambre (1) et/ou un dispositif de mesure du temps.

3. Dispositif de transfert d'échantillons selon la revendication 2 avec une platine à échantillons (5) qui est conçue pour recevoir le porte-échantillons, **caractérisé en ce que** le dispositif de mesure (8) pour la mesure de la température est disposé sur la platine à échantillons (5).

4. Dispositif de transfert d'échantillons selon l'une des revendications ci-dessus, **caractérisé en ce qu'**un accumulateur est disposé à l'intérieur ou à l'extérieur du dispositif de transfert d'échantillons (10) pour alimenter en énergie le au moins un dispositif de mesure (3, 8).

5. Dispositif de transfert d'échantillons selon l'une des revendications ci-dessus, **caractérisé en ce qu'**il est prévu un système de commande électronique (9) qui est en liaison active avec le au moins un dispositif de mesure (3, 8) de telle sorte qu'une mesure peut être initiée par le dispositif de mesure concerné (3, 8) et/ou que des valeurs de mesure du dispositif de mesure concerné (3, 8) peuvent être reçues par le système de commande électronique (9).

6. Dispositif de transfert d'échantillons selon la revendication 5, **caractérisé en ce que** l'électronique de commande (9) est disposée à l'intérieur du dispositif de transfert d'échantillons (10).

7. Dispositif de transfert d'échantillons selon l'une des revendications ci-dessus, **caractérisé en ce que** le dispositif de transfert d'échantillons (10) a une interface avec une station d'accueil (100) d'une unité de traitement ou d'analyse (200).

8. Dispositif de transfert d'échantillons selon la revendication 7, **caractérisé en ce que** l'interface est conçue de telle sorte que les valeurs de mesure du au moins un dispositif de mesure (3, 8) peuvent être transmises à l'unité de traitement ou d'analyse (200) et/ou à la station d'accueil associée (100), et/ou de telle sorte que le au moins un dispositif de mesure (3, 8) et/ou l'électronique de commande (9) selon la revendication 5 sont alimentés en courant par l'intermédiaire de l'interface.

9. Dispositif de transfert d'échantillons selon la revendication 7 ou 8, dans la mesure où il est visé par la revendication 4, **caractérisé en ce que** l'interface est conçue de telle manière que l'accumulateur peut être chargé au moyen d'une source d'énergie externe via l'interface.

10. Dispositif de transfert d'échantillons selon l'une des revendications ci-dessus, **caractérisé en ce que** le dispositif de transfert d'échantillons (10) comprend une tige de transfert (4) pour changer la position et/ou l'orientation d'un porte-échantillon fixé à la tige de transfert (4).

11. Dispositif de transfert d'échantillons selon la revendication 10, **caractérisé en ce qu'**un autre dispositif de mesure est prévu pour détecter la position et/ou l'orientation du porte-échantillon et/ou un mouvement correspondant de la tige de transfert (4).

12. Dispositif de transfert d'échantillons selon l'une des revendications ci-dessus, dans la mesure où il est renvoyé à la revendication 5, **caractérisé en ce que** l'électronique de commande (9) génère un signal d'avertissement lorsqu'une valeur mesurée du au moins un dispositif de mesure (3, 8) dépasse ou tombe en dessous d'une valeur limite prédéterminée.

13. Système comprenant un dispositif de transfert d'échantillons (10) selon l'une des revendications précédentes, dans la mesure où il est visé par la revendication 7, et une station d'accueil (100) pour une unité de traitement ou d'analyse (200).

14. Système selon la revendication 13, dans lequel l'interface du dispositif de transfert d'échantillons (10) comporte un contact (11a) et la station d'accueil (100) comporte un contact correspondant (IIb), ces contacts (11a, 11b) étant disposés et conçus de telle sorte que, lorsque le dispositif de transfert d'échantillons (10) et la station d'accueil (100) sont connectés, les contacts (11a, 11b) entrent en liaison active l'un avec l'autre.

15. Système selon la revendication 14, dans lequel la liaison fonctionnelle est conçue de telle sorte qu'après une connexion du dispositif de transfert d'échantillons (10) et de la station d'accueil (100) par l'intermédiaire des contacts (11a, 11b) du dispositif de transfert d'échantillons (10) et de la station d'accueil (100), les valeurs mesurées du au moins un dispositif de mesure (3, 8) du dispositif de transfert d'échantillons (10) sont transmis à la station d'accueil (100) et/ou à l'unité de traitement ou d'analyse associée (200) et/ou le au moins un dispositif de mesure (3, 8) et/ou l'électronique de commande (9) selon la revendication 5 sont alimentés en courant.
